# FASCICULE DE BREVET EUROPEEN

(11) **EP 3 227 906 B1**
(45) Date de publication et mention de la délivrance du brevet: **24.11.2021**
(21) Numéro de dépôt: 15805457.7
(22) Date de dépôt: 04.12.2015
(51) Int. Cl.: H01L 21/20, B82Y 10/00, H01L 29/06, H01L 31/0304, H01L 31/0352, H01L 31/0392, H01L 33/00, H01L 33/06, H01L 33/12, H01L 33/18, H01L 33/32, H01L 31/18

(54) **DISPOSITIF ELECTRONIQUE A ELEMENT FILAIRE S'ETENDANT A PARTIR D'UNE COUCHE ELECTRIQUEMENT CONDUCTRICE COMPORTANT DU CARBURE DE ZIRCONIUM OU DU CARBURE DE HAFNIUM**
ELEKTRONISCHE VORRICHTUNG MIT EINEM AUS EINER ELEKTRISCH LEITFÄHIGEN SCHICHT MIT ZIRKONCARBID ODER HAFNIUMKARBID HERAUSSTEHENDEN DRAHTELEMENT
ELECTRONIC DEVICE WITH A WIRE ELEMENT EXTENDING FROM AN ELECTROCONDUCTIVE LAYER COMPRISING ZIRCONIUM CARBIDE OR HAFNIUM CARBIDE

(30) Priorité: 05.12.2014 FR 1461965
(43) Date de publication de la demande: 11.10.2017
(73) Titulaire: Commissariat à l'Énergie Atomique et aux Énergies Alternatives, 75015 Paris (FR); Aledia, 38000 Grenoble (FR)
(72) Inventeur: DUPONT, Florian, 38000 Grenoble (FR); AMSTATT, Benoit, 38000 Grenoble (FR); HYOT, Bérangère, 38320 Eybens (FR)
(74) Mandataire: Novaimo
(86) Numéro de dépôt international: PCT/EP2015/078640
(87) Numéro de publication internationale: WO 2016/087634

(56) Documents cités:
- WO-A1-2011/162715
- WO-A1-2014/064395
- US-A1- 2010 314 627
- US-A1- 2014 117 308
- US-A1- 2014 120 637

## Description

### Domaine technique de l'invention

L'invention concerne le domaine de l'électronique, et plus particulièrement de l'opto-électronique dans le cadre de dispositifs électroniques à diode(s) électroluminescente(s) ou à cellule(s) photovoltaïque(s).

L'invention a pour objet plus particulièrement un dispositif électronique comprenant un substrat, au moins un élément filaire semi-conducteur formé par un nitrure d'un matériau du groupe III et une couche électriquement conductrice interposée entre le substrat et ledit élément filaire semi-conducteur, ledit au moins un élément filaire semi-conducteur s'étendant à partir de la couche électriquement conductrice.

### État de la technique

Dans le domaine de la croissance d'éléments filaires en nitrure d'un matériau du groupe III de la classification périodique des éléments, il est connu d'utiliser des couches dites de nucléation afin d'assurer ladite croissance. Les matériaux classiquement utilisés en tant que couche de nucléation sont l'AlN (nitrure d'aluminium), le TiN (nitrure de titane), ou encore des nitrures de métaux de transition.

Le document « From nucleation to growth of catalyst-free GaN nanowires on thin AlN buffer layer » de R. Sondmuang et al. publié en 2007 dans Appl. Phys. Lett. 91 décrit justement la croissance de nanofils à partir d'une couche d'AIN. Dans le cas de l'AlN, les couches sont fortement résistives et ne permettent pas d'assurer, dans le cas d'un dispositif émetteur de lumière, l'injection des porteurs via la base des éléments filaires et/ou la connexion électrique des éléments filaires entre eux.

Dans le cas des nitrures de métaux de transition, les dépôts sont généralement réalisés en deux étapes : une première étape de dépôt métallique, suivie d'une étape de recuit sous gaz nitrurant, qui permet de créer un nitrure de métal de transition. C'est notamment ce qui est décrit dans le document WO2014/064263. Ces deux étapes impliquent alors une augmentation de la durée et des coûts de production.

Les documents évoqués ci-dessus ne résolvent pas à la fois le problème de l'injection des porteurs par la base d'éléments filaires et le problème d'une réalisation en une seule étape de la couche de nucléation, notamment pour la réalisation de dispositifs optoélectroniques émetteurs de lumière à base de nano- ou microfils.

Le document WO2011/162715 décrit l'utilisation d'une couche tampon pour la croissance en nitrure d'un composé III-V.

US 2010/314627 A1 divulgue une méthode pour faire croître un nitrure du groupe III sur diamant, ou sur un substrat en silicium préalablement recouvert d'une couche en diamant, en employant une couche tampon de ZrC.

US 2014/120637 A1 divulgue une méthode pour croître des nanofils de GaN sur silicium en utilisant une couche tampon de nitrure de métal de transition.

US 2014/117308 A1 divulgue une méthode pour croître des nanofils GaN avec une couche tampon ZrN.

WO 2014/064395 A1 divulgue une méthode pour croître des nanofils GaN avec des îlots HfN.

En outre, dans ce domaine compétitif, il est aussi intéressant de trouver des alternatives judicieuses aux dispositifs électroniques connus.

### Objet de l'invention

Le but de la présente invention est de proposer une solution qui remédie en tout ou partie aux inconvénients listés ci-dessus. L'invention est relative à un dispositif électronique selon la revendication 1.

On tend vers ce but en ce que la couche électriquement conductrice comporte un carbure de zirconium ou un carbure de hafnium. Notamment, l'épaisseur de la couche électriquement conductrice est comprise entre 3nm et 50nm.

Avantageusement, la couche électriquement conductrice présente une cristallinité telle que les cristallites de cette dernière ont chacune une dimension, selon l'épaisseur de ladite couche électriquement conductrice, inférieure à l'épaisseur de ladite couche électriquement conductrice divisée par deux.

Le dispositif peut comporter une diode électroluminescente, ou une cellule photovoltaïque dont au moins une partie est formée par ledit au moins un élément filaire semi-conducteur.

Le substrat peut être en silicium.

L'invention est aussi relative à un procédé de fabrication d'un dispositif électronique selon la revendication 6.

Notamment, le procédé comporte, au préalable de l'étape de formation de la couche électriquement conductrice, une étape de désoxydation du substrat, notamment mise en œuvre par un plasma Argon.

En particulier, l'étape de fourniture du substrat est telle que le substrat fourni est en silicium, et présente une orientation cristallographique [100].

Notamment, la couche électriquement conductrice formée présente une structure cristalline cubique face centrée, et présente une orientation cristallographique [111].

L'étape de formation de la couche électriquement conductrice peut comporter une étape de dépôt de ladite couche électriquement conductrice utilisant une cible formée en carbure de zirconium lorsque la couche électriquement conductrice à former comporte du carbure de zirconium, ou formée en carbure de hafnium lorsque la couche électriquement conductrice à former comporte du carbure de hafnium.

Notamment, l'étape de formation dudit au moins un élément filaire semi-conducteur comporte une étape de croissance, notamment par épitaxie, d'au moins un fil d'un nitrure d'un matériau du groupe III. Dans ce cadre, l'étape de croissance peut être précédée d'une étape de montée en température d'une enceinte d'un réacteur d'épitaxie dans lequel est placé le substrat sur lequel est formée la couche électriquement conductrice, ladite étape de montée en température étant effectuée sous flux d'azote avec une rampe en température constante, notamment égale à 1,25°C/s, évoluant d'une température initiale vers une température d'épitaxie supérieure à ladite température initiale, notamment la température d'épitaxie est égale à 1000°C.

Selon une réalisation, l'étape de formation par croissance dudit au moins un élément filaire semi-conducteur est réalisée à partir de la couche électriquement conductrice formée alors que ladite couche électriquement conductrice n'a pas subi de recuit après sa formation.

Selon un mode d'exécution, le procédé comporte une étape de fonctionnalisation dudit au moins un élément filaire semi-conducteur pour former une diode électroluminescente ou une cellule photovoltaïque.

Notamment, l'étape de formation de la couche électriquement conductrice est telle que la couche électriquement conductrice formée présente une épaisseur comprise entre 3nm et 50nm.

### Description sommaire des dessins

D'autres avantages et caractéristiques ressortiront plus clairement de la description qui va suivre de modes particuliers de réalisation de l'invention donnés à titre d'exemples non limitatifs et représentés sur les dessins annexés, dans lesquels :
- la figure 1 est une vue schématique d'un dispositif selon une mise en œuvre de l'invention,
- la figure 2 est un graphique représentant une intensité en nombre de coups d'une étude de diffraction des rayons X effectuée sur une couche de ZrC,
- les figures 3 et 4 sont des graphiques représentant une intensité en nombre de coups d'une étude de diffraction des rayons X effectuée sur une même couche de ZrC avant et après traitement de cette dernière,
- la figure 5 illustre le dispositif de la figure 1 fonctionnalisé.

### Description de modes préférentiels de l'invention

Le dispositif et le procédé décrits ci-après diffèrent de l'art antérieur notamment en ce qu'ils utilisent une couche électriquement conductrice comportant du carbure de hafnium ou du carbure de zirconium à partir de laquelle s'étend au moins un élément filaire semi-conducteur. Le carbure de zirconium ou le carbure de hafnium sont de bons candidats car ils permettent de former une couche électriquement conductrice, ils possèdent une structure cristallographique compatible avec l'épitaxie d'éléments filaires, notamment en nitrure de gallium, et ils possèdent une stabilité thermique par rapport aux nitrures de hafnium et de zirconium plus élevée permettant ainsi plus de souplesse dans le processus de fabrication.

Dans la présente description, un élément filaire semi-conducteur peut être un 'microfil' ou un 'nanofil'. L'élément filaire semi-conducteur est une structure tridimensionnelle de forme allongée dont la dimension longitudinale est au moins cinq fois la ou les dimensions transversales, préférentiellement au moins dix fois. La ou les dimensions transversales sont comprises entre 5 nm et 2,5 µm. Dans certains modes de réalisation, les dimensions transversales peuvent être inférieures ou égales à environ 1 µm, de préférence comprises entre 100 nm et 300 nm. Dans certains modes de réalisation, la hauteur de chaque élément filaire peut être supérieure ou égale à 500 nm, de préférence comprise entre 1 µm et 50 µm.

De manière applicable à tout ce qui est dit dans la présente description, l'élément filaire semi-conducteur est formé par un nitrure d'un matériau du groupe (aussi appelé colonne) III. Par « un matériau du groupe III », on entend un, ou plusieurs, éléments chimique du groupe III de la classification périodique des éléments. Lorsque le matériau est formé par plusieurs éléments chimiques du groupe III, le matériau est alors un alliage d'éléments chimiques du groupe III. Préférentiellement, l'élément filaire est formé par du GaN ou du InGaN.

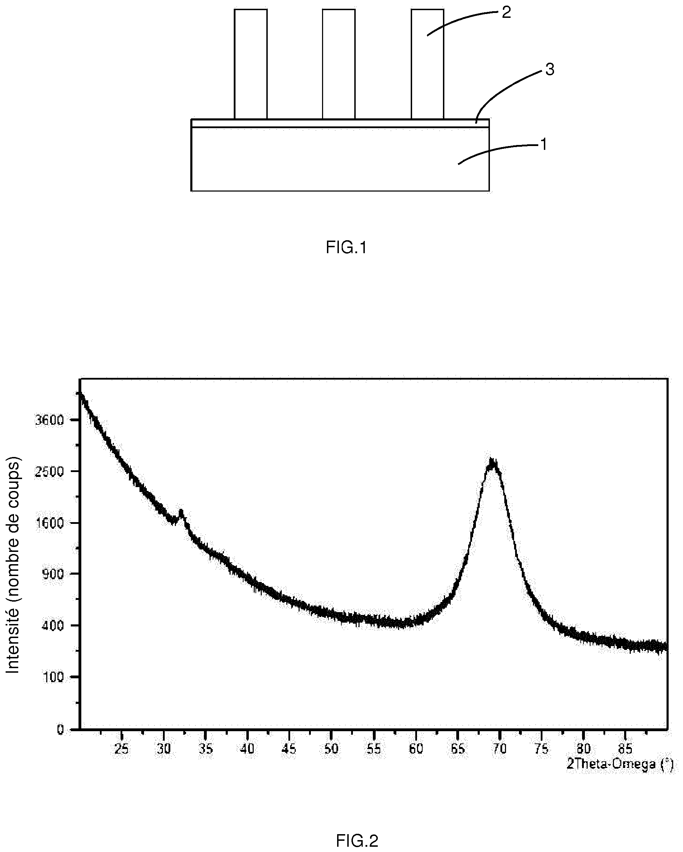

La figure 1 illustre un dispositif électronique comprenant un substrat 1, au moins un élément filaire semi-conducteur 2 formé par un nitrure d'un matériau du groupe III et une couche électriquement conductrice 3 interposée entre le substrat 1 et ledit au moins un élément filaire semi-conducteur 2. La couche électriquement conductrice 3 comporte un carbure de zirconium ou un carbure de hafnium. Ledit au moins un élément filaire 2 s'étend à partir de ladite couche électriquement conductrice 3. Autrement dit, ledit au moins un élément filaire semi-conducteur 2 comporte une extrémité longitudinale en contact physique avec la couche électriquement conductrice 3, et notamment son autre extrémité longitudinale est située à distance de ladite couche électriquement conductrice 3. En particulier, la couche électriquement conductrice 3 est formée directement sur le substrat 1.

Dans la présente description, il est fait référence à « au moins un élément filaire semi-conducteur 2 », bien entendu dans le cadre du dispositif et du procédé décrits, tout ce qui s'applique audit au moins un élément filaire semi-conducteur 2 peut s'appliquer, le cas échéant, à chaque élément filaire semi-conducteur 2 d'une pluralité d'éléments filaires semi-conducteurs 2 (figure 1) s'étendant à partir de ladite couche électriquement conductrice 3.

La conduction électrique de la couche électriquement conductrice 3 permet une fonction électrique comme la participation à l'injection de porteurs de charge dans ledit, ou à la collecte de porteurs de charge à partir dudit, au moins un élément filaire semi-conducteur 2. L'utilisation du carbure de zirconium ou du carbure de hafnium permet de réaliser cette fonction de conductivité électrique.

Lorsque le dispositif électronique comporte une pluralité d'éléments filaires semi-conducteurs 2 (figure 1), la couche électriquement conductrice 3 est avantageusement commune à chacun des éléments filaires semi-conducteurs 2. Autrement dit, l'extrémité de chaque élément filaire semi-conducteur 2 est alors en contact électrique avec ladite couche électriquement conductrice 3.

En outre, cette couche électriquement conductrice 3 comportant du carbure de zirconium ou du carbure de hafnium présente des fonctions additionnelles dans le cadre du procédé de fabrication du dispositif électronique puisqu'elle autorise la croissance d'un ou plusieurs éléments filaires semi-conducteurs 2. En effet, une telle couche électriquement conductrice 3 présente, outre sa conductivité électrique, une structure cristalline compatible avec l'épitaxie d'au moins un élément filaire semi-conducteur 2, notamment lorsque ce dernier est formé en nitrure d'un élément de la colonne (aussi appelée groupe) III de la classification périodique. Par ailleurs, contrairement aux nitrures de métaux de transition de l'art antérieur, les deux matériaux proposés dans le cadre de la présente invention (carbure de zirconium et carbure de hafnium) présentent l'avantage de pouvoir être facilement déposés en une seule étape, et de permettre, si on le souhaite, une nucléation d'éléments filaires semi-conducteur 2 sans l'utilisation d'un masque intermédiaire pour localiser des zones de nucléation.

En ce sens, l'invention est aussi relative à un procédé de fabrication d'un dispositif électronique selon la revendication 6.

La couche électriquement conductrice 3 décrite dans la présente description comporte un carbure de zirconium ou un carbure de hafnium. Autrement dit, la couche électriquement conductrice 3 peut comporter uniquement un carbure de hafnium ou un carbure de zirconium. Selon une mise en œuvre particulière, le métal carburé (choisi entre le carbure de zirconium et le carbure de hafnium) peut être noté MₓC_{y}, avec M représentant le métal utilisé (zirconium ou hafnium), C le composé carbone, x et y représentant les conditions stœchiométriques du métal carburé. Dans le cas idéal, x et y sont égaux à 1. Alternativement, en fixant x à 1, y peut varier dans une certaine mesure tout en conservant un état stable du métal carburé, cette variation est aussi appelée écart à la stœchiométrie, et est notée ΔN. En particulier, la variation peur être en cohérence avec les diagrammes de phase, par exemple le ZrC peut contenir de 38% à 50% en pourcentage atomique de carbone et le HfC peut contenir de 40% à 49% atomique de carbone. Dans ces conditions particulières de stœchiométrie, la couche électriquement conductrice 3 permet de réaliser les différentes fonctions énumérées précédemment.

Selon une réalisation, l'épaisseur de la couche électriquement conductrice 3 est comprise entre 3nm et 50nm (et plus particulièrement de 5nm à 20nm bornes incluses). Cette gamme d'épaisseur permet notamment d'assurer les différentes fonctions énumérées de la couche électriquement conductrice 3, dans le cadre du dispositif et dans le cadre du procédé de fabrication (dans ce cas, l'étape de formation de la couche électriquement conductrice 3 peut être telle que la couche électriquement conductrice 3 formée présente une épaisseur comprise entre 3nm et 50nm), dans des conditions très satisfaisantes bien qu'hors de cette gamme les fonctions puissent quand même être assurées mais de manière moins satisfaisante.

Selon la réalisation décrite immédiatement ci-dessus où l'épaisseur de la couche électriquement conductrice 3 est comprise entre 5nm et 30nm ou plus particulièrement entre 5nm et 20nm, , il a pu être établi que la conduction électrique de la couche électriquement conductrice 3 était satisfaisante et que dans le cadre du procédé les gammes d'épaisseur du perfectionnement permettaient une meilleure croissance d'élément(s) filaire(s) semi-conducteur(s). En particulier, la densité (nombre d'éléments filaires pouvant croître sur une surface donnée) et la verticalité des éléments filaires obtenus sont améliorées.

De manière générale, le substrat 1 peut être un substrat en silicium, et la couche électriquement conductrice 3 peut être formée directement sur le substrat 1.

Avantageusement, l'étape de fourniture du substrat 1 est telle que le substrat fourni 1 est en silicium, et présente une orientation cristallographique [100], notamment à la surface sur laquelle sera formée la couche électriquement conductrice 3. Cette orientation cristallographique [100] du substrat 1 en silicium permet de favoriser la formation, notamment par dépôt, de la couche électriquement conductrice 3 selon une orientation cristallographique compatible avec une croissance verticale dudit au moins un élément filaire semi-conducteur 2. La verticalité d'un élément filaire semi-conducteur 2 est donnée par rapport à un plan définissant l'horizontale et parallèle aux plans incluant respectivement le substrat 1 et la couche électriquement conductrice 3. Dans le cadre du dispositif et du procédé, ledit au moins un élément filaire semi-conducteur 2 est de préférence vertical.

Dans la présente description, une orientation cristallographique donnée est considérée comme parallèle à la perpendiculaire d'une surface, notamment planaire, de travail du substrat 1. La surface de travail du substrat 1 est notamment celle sur laquelle est formée, notamment par dépôt, la couche électriquement conductrice 3.

Selon une réalisation, le procédé comporte, au préalable de l'étape de formation de la couche électriquement conductrice 3, une étape de désoxydation du substrat 1, notamment mise en œuvre par un plasma Argon. Cette désoxydation permet de retirer l'oxyde natif du silicium, notamment au niveau de la surface de travail du substrat 1, de sorte à assurer une orientation cristallographique adaptée à l'orientation cristallographique souhaitée de la couche électriquement conductrice 3. Cette étape optionnelle de désoxydation peut être réalisée dans une chambre de dépôt de la couche électriquement conductrice 3 par l'application du plasma Argon.

De manière générale, l'étape de formation de la couche électriquement conductrice 3 sur le substrat 1 peut être réalisée par dépôt physique par phase vapeur (PVD pour « Physical Vapour Déposition » en langue anglaise). Ce dépôt est notamment réalisé à partir d'une cible formée par le matériau que l'on cherche à déposer (carbure de zirconium ou carbure de hafnium). Ainsi, l'étape de formation de la couche électriquement conductrice 3 peut comporter une étape de dépôt de ladite couche électriquement conductrice utilisant une cible formée en carbure de zirconium lorsque la couche électriquement conductrice 3 à former comporte du carbure de zirconium, ou formée en carbure de hafnium lorsque la couche électriquement conductrice 3 à former comporte du carbure de hafnium. Autrement dit, il résulte de l'étape de formation de la couche électriquement conductrice 3 que la couche déposée comporte directement (ou est formée directement par) le carbure de zirconium ou le carbure de hafnium, limitant ainsi le nombre d'étapes technologiques pour la formation de la couche électriquement conductrice 3 destinée à la nucléation d'élément(s) filaire(s). Les techniques de dépôt de cette couche électriquement conductrice 3 sont classiques, par exemple, ce dépôt peut être effectué à température ambiante ou non. Par « dépôt à température ambiante », on entend que le substrat n'est pas chauffé volontairement nonobstant l'élévation normale de température due au dépôt.

La cristallinité de la couche électriquement conductrice 3 une fois formée, notamment par dépôt, est notamment faible par rapport la cristallinité d'une couche d'épaisseur équivalente réalisée uniquement par l'élément chimique métallique (hafnium ou zirconium). Néanmoins, de manière surprenante il a été constaté que la croissance dudit au moins un élément filaire semi-conducteur 2 sur cette couche électriquement conductrice 3 directement après son dépôt permettait quand même d'atteindre des résultats comparables à ceux d'une couche dont la cristallinité aurait été plus importante. Par « croissance directe après le dépôt », on entend que la croissance dudit au moins un élément filaire semi-conducteur 2 peut être réalisée à partir de la couche électriquement conductrice 3 sans traitement supplémentaire de cette dernière pour la modifier. Notamment, la croissance dudit au moins un élément filaire semi-conducteur 2 est réalisée juste après le dépôt de la couche électriquement conductrice 3 et sans réalisation d'une étape de recuit de la couche électriquement conductrice 3 déposée qui aurait eut pour but d'augmenter sa cristallinité. Autrement dit, l'étape de formation par croissance dudit au moins un élément filaire semi-conducteur 2 peut être réalisée à partir de la couche électriquement conductrice 3 formée alors que cette dernière n'a pas subi de recuit après sa formation, notamment par dépôt. Ainsi, contre toute attente, la couche électriquement conductrice 3 peut être utilisée telle quelle pour l'épitaxie (c.-à-d. la croissance) dudit au moins un élément filaire semi-conducteur 2.

Dans la présente description, on entend par faible cristallinité que la taille des cristaux de la couche électriquement conductrice 3 déposée est inférieure à l'épaisseur de la couche déposée divisée par deux. L'épaisseur de la couche déposée est donnée selon la normale par rapport à la surface de travail évoquée précédemment. Autrement dit, la couche électriquement conductrice 3 présente une cristallinité telle que les cristallites de cette dernière ont chacune une dimension, selon l'épaisseur de la couche électriquement conductrice 3 (c'est-à-dire mesurée perpendiculairement au substrat 1), inférieure à l'épaisseur de ladite couche électriquement conductrice 3 divisée par deux. Par exemple, la dimension est préférentiellement inférieure à 10nm. La limitation de la dimension décrite dans le présent paragraphe est un préjugé vaincu, en effet, on aurait tendance à vouloir augmenter la taille des grains (cristallites) pour favoriser l'épitaxie du ou des éléments filaires. De manière surprenante, sans augmentation de la taille des cristallites selon l'épaisseur de la couche 3, la croissance du ou des éléments filaires est restée plus que satisfaisante. Une telle faiblesse dans la taille de grains permet de faciliter la réalisation en évitant une étape volontaire d'augmentation de la taille des grains.Selon une réalisation préférée, la couche électriquement conductrice 3 formée présente une structure cristalline cubique face centrée et présente une orientation cristallographique [111]. Ceci permet de favoriser la nucléation et la croissance du ou des éléments filaires semi-conducteurs 2 en particulier lorsqu'ils sont basés sur un nitrure du groupe III, notamment le nitrure de gallium. La figure 2 illustre une étude de diffraction des rayons X effectuée sur une couche de 20nm d'épaisseur de carbure de zirconium réalisée par dépôt PVD sur un substrat de silicium orienté de la manière telle que décrite précédemment, ce dépôt présente une structure selon ladite réalisation préférée car on observe bien un pic de diffraction à 32,0° qui est lié au carbure de zirconium orienté [111] (le pic de diffraction à 69° est celui lié au substrat en silicium).

Un avantage supplémentaire de l'utilisation d'une couche électriquement conductrice comportant du carbure de zirconium ou du carbure de hafnium est que la croissance dudit au moins un élément filaire semi-conducteur 2 ne provoque pas une siliciuration comme cela serait le cas si la couche était en nitrure à la place du carbure. En ce sens, l'étape de dépôt de la couche électriquement conductrice 3 n'a pas besoin de prendre en compte cette siliciuration dans le calcul de l'épaisseur à déposer en vue d'assurer la conduction électrique.

Selon un mode d'exécution, l'étape de formation dudit au moins un élément filaire semi-conducteur 2 comporte une étape de croissance, notamment par épitaxie, d'au moins un fil d'un nitrure d'un matériau du groupe III, notamment du nitrure de gallium.

L'épitaxie est une technique de croissance orientée bien connue de l'homme du métier.

Plus particulièrement, l'étape de formation par croissance dudit au moins un élément filaire semi-conducteur 2 peut mettre en œuvre une épitaxie de nitrure de gallium effectuée dans un réacteur d'épitaxie, par exemple de type épitaxie en phase vapeur aux organométalliques (aussi connu dans le domaine par l'acronyme MOCVD de l'anglais « Metalorganic Chemical Vapor Déposition »).

Après croissance, il a été observé des éléments filaires de type GaN orientés suivant leur axe 0002, et ce malgré la faible cristallinité initiale de la couche de nucléation constituée par la couche électriquement conductrice 3.

En particulier, l'étape de croissance, notamment par épitaxie, est précédée d'une étape de montée en température d'une enceinte d'un réacteur d'épitaxie dans lequel est placé le substrat 1 sur lequel est formée la couche électriquement conductrice 3, ladite étape de montée en température étant effectuée sous flux d'azote avec une rampe en température constante, et notamment égale à 1,25°C/s, évoluant d'une température initiale vers une température d'épitaxie supérieure à la température initiale, notamment la température d'épitaxie est égale à 1000°C. La rampe en température constante peut être comprise entre 0,1°C/s et 20°C/s, et plus particulièrement entre 0,5°C/s et 3°C/s. En d'autres termes, la notion de rampe en température constante traduit le fait qu'entre la température initiale et la température d'épitaxie, la température courante évolue de manière croissante sans palier. Notamment, cette montée en température est réalisée de telle manière à ne pas provoquer un recuit de la couche électriquement conductrice 3 formée, ni une nitruration ce qui pourrait endommager une surface de la couche électriquement conductrice 3 autorisant la nucléation et la croissance dudit au moins un élément filaire semi-conducteur 2. La température d'épitaxie bien que préférentiellement égale à 1000°C peut être comprise entre 900°C et 1100°C, et plus particulièrement entre 950°C et 1050°C.

L'étape de montée en température décrite ci-dessus permet de rester bien en deçà de la température de recuit de cristallisation de la couche électriquement conductrice 3, et ceci pendant un temps court par rapport à la durée normale d'une telle étape de recuit. En effet, le matériau de la couche électriquement conductrice 3 n'a alors pas assez d'énergie pour pouvoir initier une phase de croissance de ses domaines cristallins. En ce sens, cela permet de conserver, au cours de l'épitaxie du ou de(s) élément(s) filaire(s), des dimensions de cristallites selon l'épaisseur de la couche électriquement conductrice 3 telles que décrites précédemment.

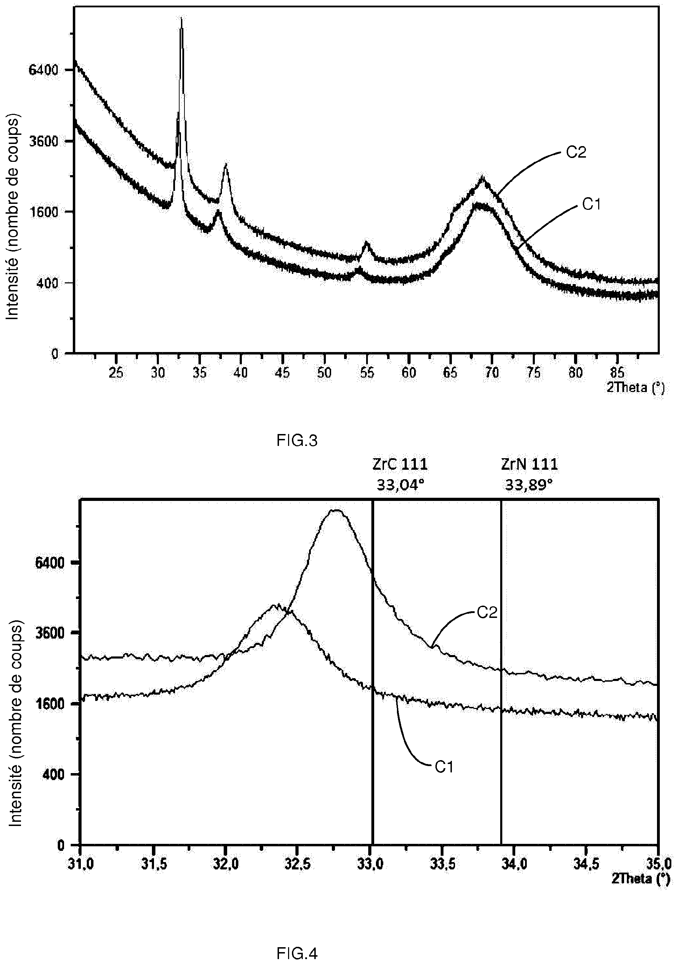

Le fait que la structure cristalline de la couche électriquement conductrice 3 n'ait pas été modifiée pendant l'étape de montée en température pré-épitaxie a été établi expérimentalement en soumettant une couche expérimentale de ZrC à une étape de montée en température pré-épitaxie en présence d'azote N₂, et éventuellement d'ammoniac NH₃. Les conditions de flux et de pressions des gaz utilisées sont des conditions classiques. Par exemple, l'enceinte d'épitaxie peut être placée à une pression qui varie entre 100mbar et 400mbar ou entre 100mbar et 1000mbar. Pour ce qui est du flux gazeux, il peut varier entre 14000sccm et 20000sccm. L'épaisseur de la couche expérimentale déposée est de 100 nm afin d'obtenir un signal de diffraction des rayons X plus intense que dans la gamme préférée entre 3nm et 50nm, permettant ainsi de mieux analyser la structure et la cristallinité de la couche expérimentale. La couche expérimentale en carbure de zirconium déposée par PVD puis ayant subi la phase de montée en température pré-épitaxie sous atmosphère nitrurante est ensuite caractérisée par diffraction des rayons X. Sur la figure 3 une première courbe C1 correspond à une mesure de diffraction des rayons X effectuée sur la couche expérimentale avant l'étape de montée en température et une deuxième courbe C2 correspond à une mesure de diffraction des rayons X effectuée sur la couche expérimentale après l'étape de montée en température. Ces deux courbes C1, C2 permettent d'identifier que la couche expérimentale présente une structure CFC (cubique face centrée) de type carbure de zirconium texturée 111 (pic situé à 32°). Après l'étape de montée en température sous atmosphère nitrurante, la structure CFC du carbure de zirconium n'a pas été modifiée avec toujours une texture 111 prononcée (le léger décalage après des pics 111 et 200 pouvant être dû à une relaxation de la couche). La figure 4 illustre une étude de diffraction où l'on a de manière plus détaillée une première courbe C1 correspondant à une mesure de diffraction des rayons X effectuée sur la couche expérimentale avant l'étape de montée en température, et une deuxième courbe C2 correspondant à une mesure de diffraction des rayons X effectuée sur la couche expérimentale après l'étape de montée en température, les ligne verticales présentent les positions théoriques des pics de diffraction du carbure de zirconium et du nitrure de zirconium. Il apparait clairement de la figure 4 que la structure CFC du carbure de zirconium ne peut en aucun cas être confondue avec la structure CFC du nitrure de zirconium. Ceci montre donc que l'épitaxie ultérieure des éléments filaires, notamment en GaN, se produit bien sur un matériau ayant une structure cristalline de carbure de zirconium et non sur un matériau ayant une structure de type nitrure de zirconium.

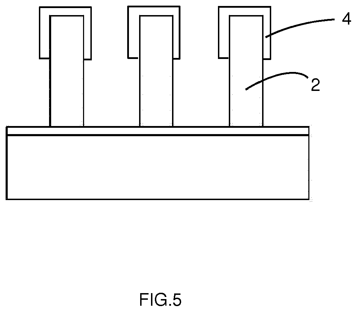

Le dispositif électronique tel que décrit peut être utilisé pour former des diodes électroluminescentes ou des cellules photovoltaïques. Notamment, l'élément filaire semi-conducteur 2 peut former tout ou partie d'une jonction destinée à émettre de la lumière, ou alternativement à en capter. Lorsque l'élément filaire semi-conducteur 2 est en nitrure de gallium, il peut notamment permettre une émission dans des longueurs d'onde bleue ou dans la totalité du spectre. Ainsi, de manière générale, le dispositif électronique peut comporter une diode électroluminescente, ou une cellule photovoltaïque dont au moins une partie est formée par ledit au moins un élément filaire semi-conducteur 2. Dans le cadre du procédé de fabrication du dispositif électronique, ce dernier peut comporter une étape de fonctionnalisation dudit au moins un élément filaire semi-conducteur 2 pour former une diode électroluminescente ou une cellule photovoltaïque. Selon un exemple particulier, ledit au moins un élément filaire semi-conducteur 2 présente un dopage électrique de type P ou N, et il est au moins en partie recouvert, avec ou sans interposition d'une couche active (non représenté) comprenant par exemple des puits quantiques, par une coquille 4 (figure 5) d'un matériau semi-conducteur dopé électriquement N ou P (de dopage opposé à celui de l'élément filaire semi-conducteur 2) de sorte à former une jonction P-N d'une diode électroluminescente ou d'une cellule photovoltaïque. Bien entendu, cet exemple n'est pas limitatif et l'homme du métier pourra réaliser d'autres fonctionnalisations.

Un avantage supplémentaire de la couche électriquement conductrice 3 comportant du carbure de zirconium ou du carbure de hafnium est qu'elle est résistante aux recettes permettant la gravure d'un masque en SiO₂ contrairement à des couches en nitrure qui sont plus facilement attaquées lors de la gravure. En ce sens, il est alors possible d'utiliser sur le dispositif électronique des dépôts ultérieurs de masques en SiO₂ qu'il est possible de graver de manière adaptée sans endommager la fonction de conductivité électrique de la couche 3. Alternativement, bien qu'il soit avantageux de permettre la croissance des éléments filaires semi-conducteurs 2 directement sur la couche électriquement conductrice 3 sans utilisation d'un masque formé sur cette dernière, il est possible former un masque en SiO₂ ajouré de sorte à former des sites préférentiels de croissance des éléments filaires semi-conducteurs sans que la formation de ce masque ne dégrade la couche 3 formée.

Selon une mise en œuvre, la couche électriquement conductrice 3 est telle qu'elle est réfléchissante à une lumière émise par le dispositif électronique au niveau dudit au moins un élément filaire semi-conducteur 2. Autrement dit, elle peut former un miroir, ceci est avantageux lorsque le dispositif doit restituer une lumière dans une direction opposée au substrat.

Alternativement, la restitution de la lumière émise par le dispositif électronique au niveau dudit au moins un élément filaire semi-conducteur 2 peut se faire au travers du substrat 1 qui est alors transparent à la lumière émise, tout comme la couche électriquement conductrice 3.

## Revendications

1. Dispositif électronique comprenant un substrat (1), au moins un élément filaire semi-conducteur (2) formé par un nitrure d'un matériau du groupe III et une couche électriquement conductrice (3) interposée entre le substrat (1) et ledit au moins un élément filaire semi-conducteur (2), ledit au moins un élément filaire semi-conducteur (2) s'étendant à partir de ladite couche électriquement conductrice (3), ledit au moins un élément filaire semi-conducteur (2) étant une structure tridimensionnelle de forme allongée dont la dimension longitudinale est supérieure à au moins cinq fois la ou les dimensions transversales, **caractérisé en ce que** la couche électriquement conductrice (3) comporte un carbure de zirconium ou un carbure de hafnium.

2. Dispositif selon la revendication précédente, **caractérisé en ce que** l'épaisseur de la couche électriquement conductrice (3) est comprise entre 3nm et 50nm.

3. Dispositif selon l'une quelconque des revendications précédentes, **caractérisé en ce que** la couche électriquement conductrice (3) présente une cristallinité telle que les cristallites de cette dernière ont chacune une dimension, selon l'épaisseur de ladite couche électriquement conductrice (3), inférieure à l'épaisseur de ladite couche électriquement conductrice (3) divisée par deux.

4. Dispositif selon l'une quelconque des revendications précédentes, **caractérisé en ce qu'**il comporte une diode électroluminescente, ou une cellule photovoltaïque dont au moins une partie est formée par ledit au moins un élément filaire semi-conducteur (2).

5. Dispositif selon l'une quelconque des revendications précédentes, **caractérisé en ce que** le substrat (1) est en silicium.

6. Procédé de fabrication d'un dispositif électronique comportant les étapes suivantes :
- une fourniture d'un substrat (1),
- une formation d'une couche électriquement conductrice (3) sur le substrat (1),
- une formation d'au moins un élément filaire semi-conducteur formé par un nitrure d'un matériau du groupe III (2) par croissance à partir de ladite couche électriquement conductrice (3), ledit au moins un élément filaire semi-conducteur (2) étant une structure tridimensionnelle de forme allongée dont la dimension longitudinale est supérieure à au moins cinq fois la ou les dimensions transversales,
**caractérisé en ce que** la couche électriquement conductrice (3) comporte un carbure de zirconium ou un carbure de hafnium.

7. Procédé selon la revendication précédente, **caractérisé en ce qu'**il comporte, au préalable de l'étape de formation de la couche électriquement conductrice (3), une étape de désoxydation du substrat (1), notamment mise en œuvre par un plasma Argon.

8. Procédé selon l'une des revendications 6 ou 7, **caractérisé en ce que** l'étape de fourniture du substrat (1) est telle que le substrat (1) fourni est en silicium, et présente une orientation cristallographique [100].

9. Procédé selon l'une quelconque des revendications 6 à 8, **caractérisé en ce que** la couche électriquement conductrice (3) formée présente une structure cristalline cubique face centrée, et présente une orientation cristallographique [111].

10. Procédé selon l'une quelconque des revendications 6 à 9, **caractérisé en ce que** l'étape de formation de la couche électriquement conductrice (3) comporte une étape de dépôt de ladite couche électriquement conductrice (3) utilisant une cible formée en carbure de zirconium lorsque la couche électriquement conductrice (3) à former comporte du carbure de zirconium, ou formée en carbure de hafnium lorsque la couche électriquement conductrice (3) à former comporte du carbure de hafnium.

11. Procédé selon l'une quelconque des revendications 6 à 10, **caractérisé en ce que** l'étape de formation dudit au moins un élément filaire semi-conducteur (2) comporte une étape de croissance, notamment par épitaxie, d'au moins un fil d'un nitrure d'un matériau du groupe III.

12. Procédé selon la revendication précédente, **caractérisé en ce que** l'étape de croissance est précédée d'une étape de montée en température d'une enceinte d'un réacteur d'épitaxie dans lequel est placé le substrat (1) sur lequel est formée la couche électriquement conductrice (3), ladite étape de montée en température étant effectuée sous flux d'azote avec une rampe en température constante évoluant d'une température initiale vers une température d'épitaxie supérieure à ladite température initiale.

13. Procédé selon l'une quelconque des revendications 6 à 12, **caractérisé en ce que** l'étape de formation par croissance dudit au moins un élément filaire semi-conducteur (2) est réalisée à partir de la couche électriquement conductrice (3) formée alors que ladite couche électriquement conductrice (3) n'a pas subi de recuit après sa formation.

14. Procédé selon l'une quelconque des revendications 6 à 13, **caractérisé en ce qu'**il comporte une étape de fonctionnalisation dudit au moins un élément filaire semi-conducteur (2) pour former une diode électroluminescente ou une cellule photovoltaïque.

15. Procédé selon l'une quelconque des revendications 6 à 14, **caractérisé en ce que** l'étape de formation de la couche électriquement conductrice (3) est telle que la couche électriquement conductrice (3) formée présente une épaisseur comprise entre 3nm et 50nm.

## Patentansprüche

1. Elektronische Vorrichtung, die ein Substrat (1), mindestens ein Halbleiterdrahtelement (2), das aus einem Nitrid eines Materials der Gruppe III gebildet ist, und eine elektrisch leitfähige Schicht (3), die zwischen dem Substrat (1) und dem mindestens einen Halbleiterdrahtelement (2) eingefügt ist, beinhaltet, wobei das mindestens eine Halbleiterdrahtelement (2) aus der elektrisch leitfähigen Schicht (3) heraussteht, wobei das mindestens eine Halbleiterdrahtelement (2) eine dreidimensionale Struktur mit länglicher Form ist, deren Längsabmessung um mindestens das Fünffache größer als die eine oder die mehreren Querabmessungen ist, **dadurch gekennzeichnet, dass** die elektrisch leitfähige Schicht (3) ein Zirkoniumcarbid oder ein Hafniumcarbid umfasst.

2. Vorrichtung nach dem vorhergehenden Anspruch, **dadurch gekennzeichnet, dass** die Dicke der elektrisch leitfähigen Schicht (3) zwischen 3 nm und 50 nm liegt.

3. Vorrichtung nach einem der vorhergehenden Ansprüche, **dadurch gekennzeichnet, dass** die elektrisch leitfähige Schicht (3) eine derartige Kristallinität aufweist, dass die Kristallite dieser letzteren gemäß der Dicke der elektrisch leitfähigen Schicht (3) jeweils eine Abmessung aufweisen, die kleiner als die Dicke der elektrisch leitfähigen Schicht (3) geteilt durch zwei ist.

4. Vorrichtung nach einem der vorhergehenden Ansprüche, **dadurch gekennzeichnet, dass** sie eine Elektrolumineszenzdiode oder eine photovoltaische Zelle, von der mindestens ein Teil durch das mindestens eine Halbleiterdrahtelement (2) gebildet wird, umfasst.

5. Vorrichtung nach einem der vorhergehenden Ansprüche, **dadurch gekennzeichnet, dass** das Substrat (1) aus Silicium ist.

6. Verfahren zur Herstellung einer elektronischen Vorrichtung, das die folgenden Schritte umfasst:
- Bereitstellen eines Substrats (1),
- Bilden einer elektrisch leitfähigen Schicht (3) auf dem Substrat (1),
- Bilden mindestens eines Halbleiterdrahtelements (2), das aus einem Nitrid eines Materials der Gruppe III gebildet ist, durch Aufwachsen auf die elektrisch leitfähige Schicht (3), wobei das mindestens eine Halbleiterdrahtelement (2) eine dreidimensionale Struktur mit länglicher Form ist, deren Längsabmessung um mindestens das Fünffache größer als die eine oder die mehreren Querabmessungen ist,
**dadurch gekennzeichnet, dass** die elektrisch leitfähige Schicht (3) ein Zirkoniumcarbid oder ein Hafniumcarbid umfasst.

7. Verfahren nach dem vorhergehenden Anspruch, **dadurch gekennzeichnet, dass** es vor dem Schritt des Bildens der elektrisch leitfähigen Schicht (3) einen Schritt der Desoxidation des Substrats (1), insbesondere umgesetzt durch ein Argonplasma, umfasst.

8. Verfahren nach einem der Ansprüche 6 oder 7, **dadurch gekennzeichnet, dass** der Schritt des Bereitstellens des Substrats (1) derart ist, dass das bereitgestellte Substrat (1) aus Silicium ist und eine kristallografische Orientierung [100] aufweist.

9. Verfahren nach einem der Ansprüche 6 bis 8, **dadurch gekennzeichnet, dass** die gebildete elektrisch leitfähige Schicht (3) eine kubisch flächenzentrierte Kristallstruktur aufweist und eine kristallografische Orientierung [111] aufweist.

10. Verfahren nach einem der Ansprüche 6 bis 9, **dadurch gekennzeichnet, dass** der Schritt des Bildens der elektrisch leitfähigen Schicht (3) einen Schritt des Aufbringens der elektrisch leitfähigen Schicht (3) unter Verwendung eines Targets umfasst, welches aus Zirkoniumcarbid gebildet ist, wenn die zu bildende elektrisch leitfähige Schicht (3) Zirkoniumcarbid umfasst, oder aus Hafniumcarbid gebildet ist, wenn die zu bildende elektrisch leitfähige Schicht (3) Hafniumcarbid umfasst.

11. Verfahren nach einem der Ansprüche 6 bis 10, **dadurch gekennzeichnet, dass** der Schritt des Bildens des mindestens einen Halbleiterdrahtelements (2) einen Schritt des Aufwachsens, insbesondere durch Epitaxie, mindestens eines Drahts aus einem Nitrid eines Materials der Gruppe III umfasst.

12. Verfahren nach dem vorhergehenden Anspruch, **dadurch gekennzeichnet, dass** dem Schritt des Aufwachsens ein Schritt des Erhöhens der Temperatur eines Behälters eines Epitaxiereaktors vorausgeht, in den das Substrat (1), auf dem die elektrisch leitfähige Schicht (3) gebildet ist, eingelegt ist, wobei der Schritt des Erhöhens der Temperatur unter Stickstoffstrom mit einer konstanten Temperaturrampe erfolgt, die sich von einer Anfangstemperatur zu einer Epitaxietemperatur, die größer als die Anfangstemperatur ist, entwickelt.

13. Verfahren nach einem der Ansprüche 6 bis 12, **dadurch gekennzeichnet, dass** der Schritt des Bildens des mindestens einen Halbleiterdrahtelements (2) durch Aufwachsen ausgehend von der gebildeten elektrisch leitfähigen Schicht (3) durchgeführt wird, wobei die elektrisch leitfähige Schicht (3) nach ihrer Bildung keinem Glühen unterzogen wurde.

14. Verfahren nach einem der Ansprüche 6 bis 13, **dadurch gekennzeichnet, dass** es einen Schritt der Funktionalisierung des mindestens einen Halbleiterdrahtelements (2) umfasst, um eine Elektrolumineszenzdiode oder eine photovoltaische Zelle zu bilden.

15. Verfahren nach einem der Ansprüche 6 bis 14, **dadurch gekennzeichnet, dass** der Schritt des Bildens der elektrisch leitfähigen Schicht (3) derart ist, dass die gebildete elektrisch leitfähige Schicht (3) eine Dicke zwischen 3 nm und 50 nm aufweist.

## Claims

1. An electronic device comprising a substrate (1), at least one semiconductor wire element (2) formed by a nitride of a group III material and an electroconductive layer (3) interposed between the substrate (1) and said at least one semiconductor wire element (2), said at least one semiconductor wire element (2) extending from said electroconductive layer (3), wherein said at least one semiconductor wire element (2) is a three-dimensional structure of elongated shape whose longitudinal dimension is greater than at least five times the transverse dimension or dimensions, **characterized in that** the electroconductive layer (3) comprises a carbide of zirconium or a carbide of hafnium.

2. The device as claimed in the preceding claim, **characterized in that** the thickness of the electroconductive layer (3) is in the range between 3nm and 50nm.

3. The device as claimed in any one of the preceding claims, **characterized in that** the electroconductive layer (3) exhibits a crystallinity such that the crystallites of the latter each have a dimension, in the thickness of said electroconductive layer (3), less than half the thickness of said electroconductive layer (3).

4. The device as claimed in any one of the preceding claims, **characterized in that** it comprises a light-emitting diode, or a photovoltaic cell of which at least a part is formed by said at least one semiconductor wire element (2).

5. The device as claimed in any one of the preceding claims, **characterized in that** the substrate (1) is made of silicon.

6. A method of fabrication of an electronic device comprising the following steps:
- supplying a substrate (1),
- forming an electroconductive layer (3) on the substrate (1),
- forming at least one semiconductor wire element composed of a nitride of a group III material (2) by growth starting from said electroconductive layer (3), wherein said at least one semiconductor wire element (2) is a three-dimensional structure of elongated shape whose longitudinal dimension is greater than at least five times the transverse dimension or dimensions,
**characterized in that** the electroconductive layer (3) comprises a carbide of zirconium or a carbide of hafnium.

7. The method as claimed in the preceding claim, **characterized in that** it comprises, prior to the step for formation of the electroconductive layer (3), a step for de-oxidation of the substrate (1) notably implemented by an argon plasma.

8. The method as claimed in either of claims 6 and 7, **characterized in that** the step for supplying the substrate (1) is such that the substrate (1) supplied is made of silicon and exhibits a [100] crystallographic orientation.

9. The method as claimed in any one of claims 6 to 8, **characterized in that** the electroconductive layer (3) formed exhibits a face-centered cubic crystalline structure and has a [111] crystallographic orientation.

10. The method as claimed in any one of claims 6 to 9, **characterized in that** the step for formation of the electroconductive layer (3) comprises a step for deposition of said electroconductive layer (3) using a target composed of zirconium carbide when the electroconductive layer (3) to be formed comprises zirconium carbide, or composed of hafnium carbide when the electroconductive layer (3) to be formed comprises hafnium carbide.

11. The method as claimed in any one of claims 6 to 10, **characterized in that** the step for formation of said at least one semiconductor wire element (2) comprises a step for growth, notably by epitaxy, of at least one wire of a nitride of a group III material.

12. The method as claimed in the preceding claim, **characterized in that** the growth step is preceded by a step for raising the temperature of an epitaxy reaction chamber in which the substrate (1) is placed, on which the electroconductive layer (3) is formed, said step for raising the temperature being carried out under a flow of nitrogen with a constant temperature ramp rising from an initial temperature to an epitaxy temperature higher than said initial temperature.

13. The method as claimed in any one of claims 6 to 12, **characterized in that** the step for formation by growth of said at least one semiconductor wire element (2) is carried out starting from the electroconductive layer (3) formed, whereas said electroconductive layer (3) has not been subjected to an annealing after its formation.

14. The method as claimed in any one of claims 6 to 13, **characterized in that** it comprises a step for functionalization of said at least one semiconductor wire element (2) in order to form a light-emitting diode or a photovoltaic cell.

15. The method as claimed in any one of claims 6 to 14, **characterized in that** the step for formation of the electroconductive layer (3) is such that the electroconductive layer (3) formed has a thickness in the range between 3nm and 50nm.
